# EUROPEAN PATENT SPECIFICATION

(11) **EP 4 020 030 B1**
(45) Date of publication and mention of the grant of the patent: **04.11.2026**
(21) Application number: 21209148.2
(22) Date of filing: 18.11.2021
(51) Int. Cl.: G02B 6/26, G02B 6/42

(54) **SYSTEM WITH ACTIVE OPTICAL COUPLER APPARATUS**
SYSTEM MIT AKTIVEM OPTISCHEN KOPPLER
SYSTEME AVEC COUPLEUR OPTIQUE ACTIF

(30) Priority: 23.12.2020 US 202017132955
(43) Date of publication of application: 29.06.2022
(73) Proprietor: INTEL Corporation, Santa Clara, CA 95054 (US)
(72) Inventor: PRATAP, Divya, Hillsboro, 97124 (US); NEKKANTY, Srikant, Chandler, 85286 (US)
(74) Representative: 2SPL Patentanwälte PartG mbB

(56) References cited:
- US-A- 4 904 036
- US-A1- 2004 105 611
- US-A1- 2020 003 971
- US-B1- 9 547 142

## Description

### FIELD

Embodiments of the present disclosure generally relate to the field of semiconductor packaging, and in particular to photonics coupling to a photonics package.

### BACKGROUND

Continued growth in virtual machines and cloud computing will increase the demand for reliable manufactured semiconductor packages, including optical packages.

US 2004/105611 A1 discloses an optical assembly, such as a multiple output diode laser pump source for EDFAs, is formed by pressing an optical array emitter chip against a standoff structure protruding from a submount such that the emitter chip deforms to match the curvature of the standoff structure. An IO chip is also juxtaposed against the standoff structure such that its optical receivers can receive optical energy from the emitter chip. Detectors to monitor the output power of the laser emitters, allowing control of the pump source output in response to control signals are part of the optical assembly.

US 4 904 036 A discloses a method for ascertaining material characteristics of an object, in particular optical properties of preferably semi-transparent objects. This is achieved in that spectrally resolved data from measured data of the object are calculated with spectrally resolved data of a reference body in order to ascertain the material characteristics, the measured data being ascertained with a confocal 3D measuring system.

US 2020/003971 A1 discloses an apparatus to reduce the manufacturing time, the cost of parts, and the cost of assembly per laser for photonic interconnects incorporated into computing systems. An output side of a laser assembly is placed against an input side of a silicon interposer (SiP) such that each pad in a plurality of pads positioned on the output side of the laser assembly is in contact with a respective solder bump that is also in contact with a corresponding pad positioned on the input side of the SiP. The laser assembly is configured to emit laser light from the output side into an input grating of the SiP. The solder bumps are heated to a liquid phase. Capillary forces of the solder bumps realign the laser assembly and the SiP while the solder bumps are in the liquid phase. The solder bumps are then allowed to cool.

US 9 547 142 B1 discloses a tracheal cannula which obturates the trachea as hermetically as possible for ventilating a patient, the device comprising a cuffed balloon which blocks the trachea below the glottis and through which a ventilating cannula is passed, with the cuffed balloon when filled or inflated and freely unfolded without any limitation, being larger than when placed in the trachea in an inflated state, and being made from a soft flexible foil material. To intubate a patient with said device as gently as possible at low pressures over a long period of time and with a low risk of infection, the invention suggests that the draped fold of the cuffed balloon should rest on the trachea and be designed in such a way that the loop created at the dead end of a fold has a small diameter which inhibits the free flow of secretion through the loop of said fold.

### BRIEF DESCRIPTION OF THE DRAWINGS

FIG. 1 illustrates a photonics package on a motherboard with an optical coupler at an edge of the package.
FIG. 2 illustrates a functional diagram of an active optical coupler.
FIG. 3 illustrates one example of incorporating an active optical coupler into a photonics package.
FIG. 4 illustrates another example of incorporating an active optical coupler into a photonics package that includes a retention feature.
FIG. 5 illustrates another example of incorporating an active optical coupler with alignment pins into a photonics package.
FIG. 6 illustrates another example of incorporating an active optical coupler with alignment holes into a photonics package.
FIG. 7 illustrates a removable optical adapter.
FIG. 8 illustrates an optical adapter mounted on a motherboard and coupled with a photonics package, in accordance with various embodiments.
FIG. 9 illustrates details of an enhanced adapter used in the system according to the claimed invention.
FIG. 10 illustrates an active optical coupler that includes photonic crystal fiber (PCF).
FIG. 11 illustrates an optical adapter mounted on a motherboard that includes optical lenses coupled with a photonics package, in accordance with various embodiments.
FIG. 12 illustrates an optical adapter mounted on a motherboard that includes an optical pathway to optically couple an optical layer of the motherboard with the photonics package, in accordance with various embodiments.
FIG. 13 is a process for implementing an active optical coupler with a photonics package.
FIG. 14 is a schematic of a computer system.

### DETAILED DESCRIPTION

The claimed invention relates to systems comprising optical couplers that provide optical coupling at or proximate to an edge of a photonics package, to allow the package to couple with other devices or peripherals. In embodiments, the optical coupler is optically coupled with a photonics IC (PIC) inside the photonics package, and provides an optical coupling mechanism for optical pathways outside the photonics package. In embodiments, the photonics packages may have a PIC that is in close physical proximity to a system-on-a-chip (SOC) or some other processing die, that may require the PIC to be disposed in a central position within the photonics package. In embodiments, optical couplers may allow a convenient way for customers to optically couple photonics packages.

In addition, in embodiments, the optical coupler may not be in physical contact with the heat spreader. This may result in a gap between the heat spreader and the optical coupler to allow access to internal chambers of the photonics package. This access may facilitate cleaning of the package, for example as a part of regular maintenance of systems of which the photonics package is a part. In embodiments, this access may also facilitate disassembly of the package for cleaning or other maintenance procedures. Embodiments described herein may be directed to facilitating ease-of-use for optical coupling, while still keeping the fiber-connector assembly limited to the photonics package, which may also be referred to as the photonics package footprint.

Embodiments not according to the claimed invention may also describe active optical couplers that may physically couple with a substrate of the photonics package and also electrically couple with the substrate to provide monitoring and/or telemetry data for the operation of the active optical coupler. Embodiments not according to the claimed invention may also describe various adapters which can overhang or extend the reach of an optical coupler outside of the heatsink shadow, as well as provide additional optical pathway routing and/or analysis function of the performance of the adapter.

These embodiments may enable a highly reliable optical coupling mechanism, and may also facilitate optical signal monitoring on-field, such as customer sites. According to the claimed invention, such active optical couplers include circuitry monitoring that includes optical signal strength, may have optical fiber already attached, are mounted on a motherboard and may be coupled with thermal hardware or other package structures to give structural rigidity and alignment for the coupler or adapter. In embodiments, the adapter may include lenses for optical transmission, and may include PCF fibers integrated within the adapter to facilitate operational analysis and reporting. In embodiments, the adapter may also enable telemetry to monitor and store optical signal strength.

Photonics packages that include a silicon photonic engine/optical fiber module are increasingly being included in a same package as the main SOC. Such legacy packaging solution involves assembly of optical fiber connector subassemblies (referred to as "pigtails") attached to the PIC. It is desirable to limit the length of these pigtails within a photonics package footprint for high volume manufacturing and assembly, test, and shipping and handling of these packages. Implementations that include passive fiber connectors within a photonics package footprint may create difficulty for mating with external connectors. A customer must reach underneath a heatsink base that typically overhangs a heat spreader to connect the main optical fiber connector.
In addition, plugging in and unplugging male or female connectors becomes complex and impractical as the heatsink, or other system thermal solution, must be disassembled and reassembled after deployment for periodic cleaning.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

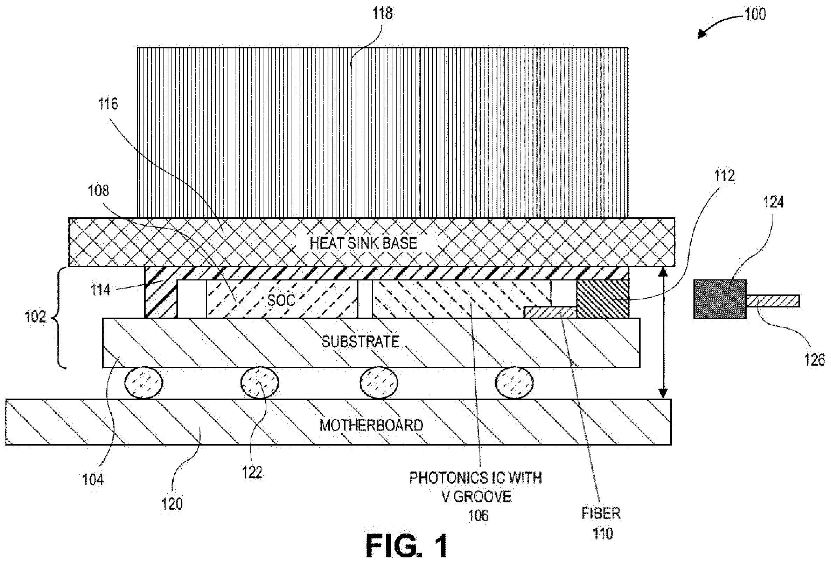

FIG. 1 illustrates a photonics package on a motherboard with an optical coupler at an edge of the package. System 100 shows a photonics package 102 that includes a substrate 104, a PIC 106 and SOC 108 coupled with substrate 104. In implementations, the SOC 108 may be an XPU, a central processing unit (CPU), a graphics processing unit (GPU), field programmable gate array (FPGA), an application specific integrated circuit (ASIC), an accelerator, or some other processing chip or die. In implementations, the SOC 108 and the PIC 106 may be electrically coupled (not shown) using an interconnect bridge, an embedded multi-die interconnect bridge (EMIB), a silicon interposer, organic routing on the substrate 104 or a redistribution layer (RDL) on the substrate 104. Note that the optical connector 112 in legacy implementations may be physically coupled with substrate 104, but not electrically coupled.

Optical fibers 110 may optically couple the PIC 106 with the optical connector 112. In implementations, a heat spreader 114 thermally couples and/or physically couples with the SOC 108, the PIC 106, and the optical connector 112. In implementations, the heat spreader 114 physically couples with the substrate 104. In implementations, the optical fibers 110 may be waveguides, open air channels, or some other optical pathway to allow optical coupling between the PIC 106 and the connector 112 within the photonics package 102. In implementations, a heatsink base 116 may be thermally and/or physically coupled with the heat spreader 114. Other cooling elements, for example cooling fins 118, may be thermally and physically coupled to the heatsink base 116.

As shown, the photonics package 102 may be coupled with a motherboard 120 via a ball grid array (BGA) 122. In embodiments, other electrical and/or physical coupling methods and techniques may be used to couple the motherboard 120 with the substrate 104. In implementations, an external connector 124 that is optically coupled with optical fibers 126, may be owned by a customer and inserted into connector 112 by the customer during installation. Note that it is difficult to reach underneath the heatsink base 116 and the heat spreader 114 to plug in the connector 124 to optical connector 112. Plugging and unplugging the connector 124 may be difficult without disassembling the heatsink 116 or the heat spreader 114 from the photonics package 102.

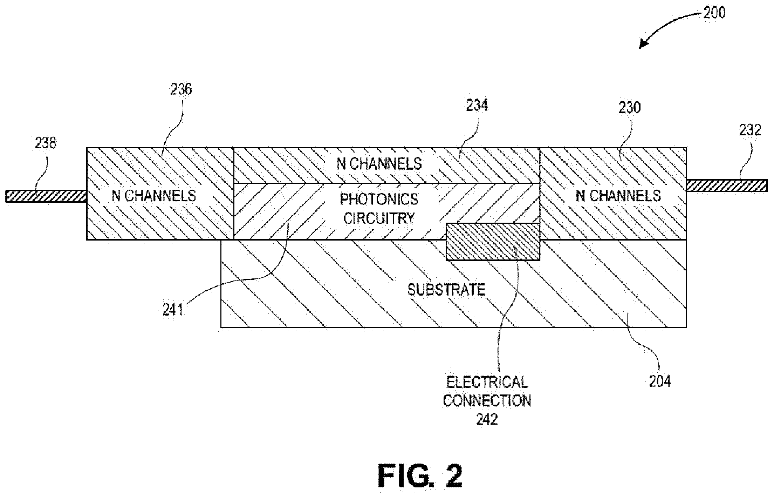

FIG. 2 illustrates a functional diagram of an active optical coupler not according to the claimed invention. Active optical coupler 200, which may be similar to optical coupler 112 of FIG. 1, includes a first optical interface 230 to receive light signals from up to N channels from optical fibers 232. In embodiments, the first optical interface 230 may include a physical socket (not shown) or other similar receiving features to facilitate the insertion of the optical fibers 232, into the first optical interface 230. For example, using a coupler such as coupler 124 of FIG. 1. Optical paths 234 couple light received from the first optical interface 230 to a second optical interface 236. In embodiments, the optical paths 234 may include waveguides, one or more optical fibers, or open air connectors to allow an optical coupling between the first optical interface 230 and the second optical interface 236, that may be optically coupled with optical fibers 238.

The active optical coupler 200 may also include photonics circuitry 241 that may be used to sample and/or monitor the light traveling in the optical paths 234. In embodiments, the photonics circuitry 241 may include one or more single-channel splitters, photodiodes, and other photonics-related components to sense and to collect operational data related to the active optical coupler 200. The photonics circuitry 241 may also be used to monitor other operational aspects of the active optical coupler 200 outside of optical performance, for example operating temperature or bandwidth.

In embodiments not according to the claimed invention, the photonics circuitry 241 may be electrically coupled via an electrical connection 242 to a substrate 204, which may be similar to substrate 104 of FIG. 1. According to the claimed invention, electrical connection 242 is coupled to a motherboard, such as motherboard 120 of FIG. 1. In embodiments, the electrical connection 242 may provide an electrical coupling with some other processing or storage component (not shown), for example with the PIC 106, and/or the SOC 108 of FIG. 1. In embodiments not according to the claimed invention, the electrical connection 242 may be an interconnect bridge, such as an EMIB, or a silicon interposer, organic routing on the substrate 204 or a RDL on the substrate 204, or some other electrical coupling. In embodiments, the electrical coupling may be a high density electrical coupling. Using the electrical connection 242, data collected by the photonics circuitry 241 may enable telemetry regarding the operation of the active optical coupler 200.

For example, the active optical coupler 200 may actively draw current from the substrate 204, or leverage onboard amplifiers on the motherboard or pre-existing integrated circuits on the PIC 106 of FIG. 1 to measure, monitor, or store, for example, optical signal strength. In embodiments, the photonics circuitry 241 may include an N+1 channel adapter, which may include N optical channels for regular transmission and reception of optical signals, and 1 channel to enable telemetry. The N+1 channel adapter may include a single-channel splitter that operates in a special mode to periodically monitor and store optical output power of the active optical coupler 200. In embodiments, the active optical coupler 200, with varying components in the photonics circuitry 241, may be configured for benchtop, on-field, or final system-level testing.

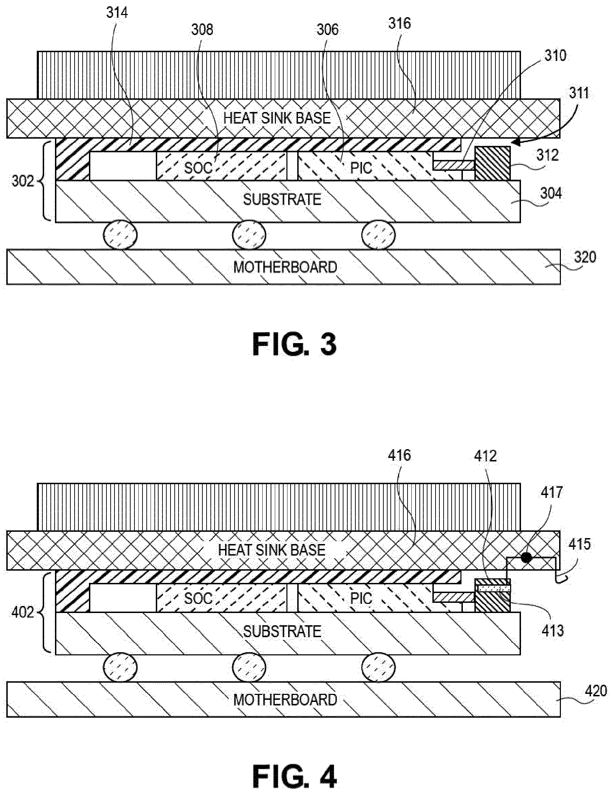

FIG. 3 illustrates one example not being part of the claimed invention of incorporating an active optical coupler into a photonics package. Photonics package 302, which may be similar to photonics package 102 of FIG. 1, is coupled with a motherboard 320, which may be similar to motherboard 120 of FIG. 1. Package 302 includes substrate 304, coupled with PIC 306 and SOC 308, which may be similar to substrate 104, PIC 106, and SOC 108 of FIG. 1. Active optical coupler 312, which may be similar to active optical coupler 200 of FIG. 2, is shown optically coupled with the PIC 306 through optical couplings 310. The optical couplings 310 may be fibers, a waveguide, or an open air channel.

The active optical coupler 312 may be physically coupled with the substrate 304. In embodiments, this physical coupling may be accomplished through application of an adhesive, such as an epoxy, between the active optical coupler 312 and the substrate 304, mechanical cuts such as holes or grooves within the substrate, or by soldering. Note that air gap 311 exists between the heatsink base 316, which may be similar to heatsink base 116 of FIG. 1, and the active optical coupler 312 to provide physical access into the photonics package 302. Note that in embodiments, the heat spreader 314, which may be similar to heat spreader 114 of FIG. 1, does not come into contact with the active optical coupler 312.

FIG. 4 illustrates another example not being part of the claimed invention of incorporating an active optical coupler into a photonics package that includes a retention feature. Photonics package 402 coupled with a motherboard 420 may be similar to photonics package 302 coupled with motherboard 320 of FIG. 3. The active optical coupler 412, which may be similar to active optical coupler 312 of FIG. 3, includes a guide hole 413 in the active optical coupler 412 to facilitate accurate alignment when an external optical coupler is inserted into the active optical coupler 412. For example, an alignment pin may insert into guide hole 413. In embodiments, there may be multiple guide holes 413 to receive multiple alignment pins that may be a part of the external optical coupler. Note that the guide hole 413 is shown as a hole, however it may have any shape, extending into or extending out of the active optical coupler 412.

In addition, a retention mechanism 415 may be coupled with the heatsink base 416, which may be similar to heatsink base 316 of FIG. 3. In embodiments, this retention mechanism 415 may be a spring that is secured to the heatsink base 416 using a pin 417. Other embodiments may use some other securing mechanism. In embodiments, there may be one or more retention mechanisms 415 coupled with heatsink base 416. As shown, the retention mechanism 415 may be bent, or have another shape and/or other features, that may press against a side of an external optical coupler to provide a mechanical force to secure the external optical coupler to the active optical coupler 412.

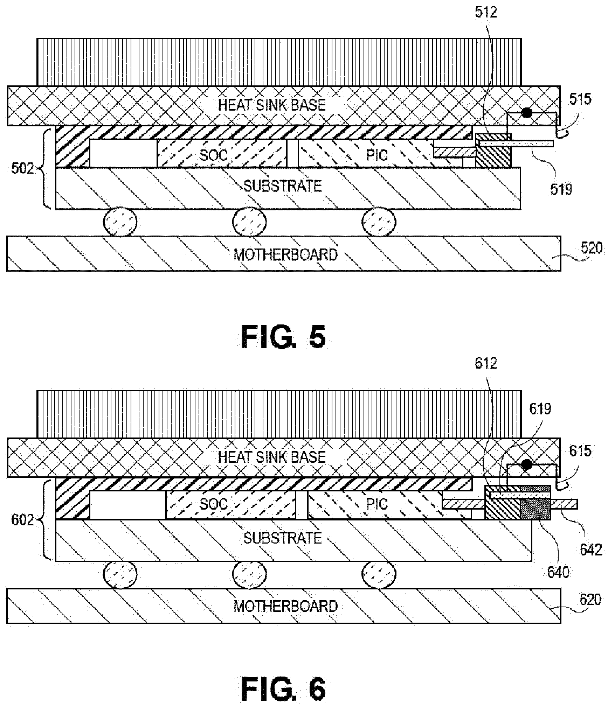

FIG. 5 illustrates another example not being part of the claimed invention of incorporating an active optical coupler with alignment pins into a photonics package. Photonics package 502 coupled to a motherboard 520 may be similar to photonics package 402 coupled to a motherboard 420 of FIG. 4., The active optical coupler 512, which may be similar to active optical coupler 412 of FIG. 4, may include a retention mechanism 515, which may be similar to retention mechanism 415 of FIG. 4. As shown, the active optical coupler 512 may include an alignment pin 519 that is physically coupled with the active optical coupler 512. In embodiments, there may be more than one alignment pin 519. In embodiments, the alignment pin 519 is to fit into an alignment hole in an external optical coupler as described further below.

FIG. 6 illustrates another example not being part of the claimed invention of incorporating an active optical coupler with alignment holes into a photonics package. Photonics package 602 coupled to a motherboard 620 may be similar to photonics package 502 coupled to a motherboard 520 of FIG. 5. Here, the active optical coupler 612, which may be similar to active optical coupler 512 of FIG. 5, is physically and optically coupled with an external optical coupler 640. The external optical coupler 640 may be optically coupled with one or more optical fibers 642.

The pin 619, which may be similar to pin 519 of FIG. 5, may be inserted between the active optical coupler 612 and the external optical coupler 640. In embodiments, there may be multiple pins 619. These pins 619 may be used to precisely align the surfaces of the optical pads, for example optical fibers, when the external optical coupler 640 and the active optical coupler 612 are coupled. In addition, retention mechanism 615, which may be similar to retention mechanism 515 of FIG. 5, is shown applying pressure to a side of the external optical coupler 642. This applied pressure may provide a mechanical pressure to facilitate a high-quality optical coupling between the active optical coupler 612 and the external optical coupler 640 and retention of the external coupler 640

Note that in embodiments described herein, the external optical coupler 640 may be a male coupler, and the active optical coupler 612 may be a female coupler, or the external optical coupler 640 may be a female coupler, and the active optical coupler 612 may be a male coupler.

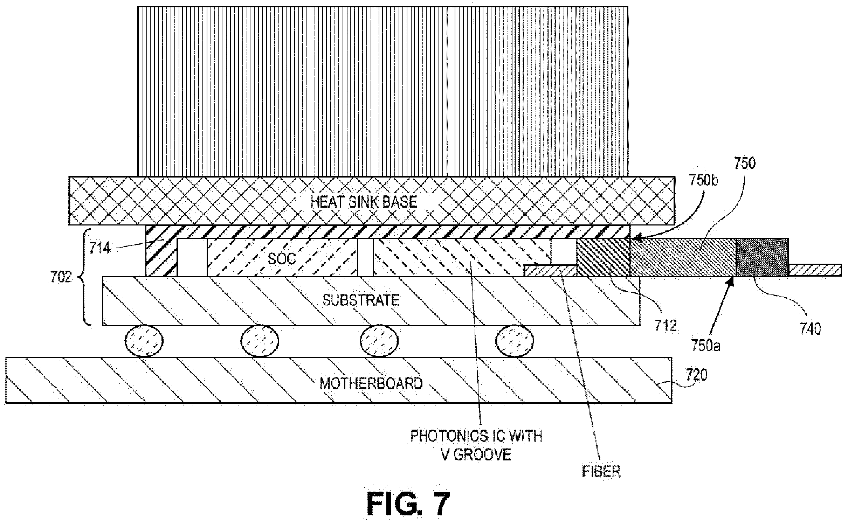

FIG. 7 illustrates a removable optical adapter. embediments- Photonics package 702, which may be similar to photonics package 602 of FIG. 6, may be coupled to a motherboard 720 which may be similar to motherboard 620 of FIG. 6. The optical coupler 712, which may be similar to active optical coupler 612 of FIG. 6 or the optical coupler 112 of FIG. 1, may be physically and optically coupled with a removable optical adapter 750. In embodiments, not according to the claimed invention, the optical adapter 750 may be secured to a side of the optical coupler 712. The optical adapter 750 may be removably and optically coupled with the external optical coupler 740.

Optical adapter 750 may have a first side 750a that is to couple with the external optical coupler 740, and a second side 750b that is to couple with the optical coupler 712, which in embodiments not according to the claimed invention may be an active optical coupler. The first side 750a of the optical adapter 750 that is to couple with the external optical coupler 740 may be designed for one or more standard coupling configurations. Thus, the second side 750b of the adapter 750 may be designed in a configuration that may be unique to the configuration of the optical coupler 712.

The adapter 750, during operation, transmits optical signals received from the external optical coupler 740 the active optical coupler 712, and transmits optical signals received from the active optical coupler 712 to the external optical coupler 740.

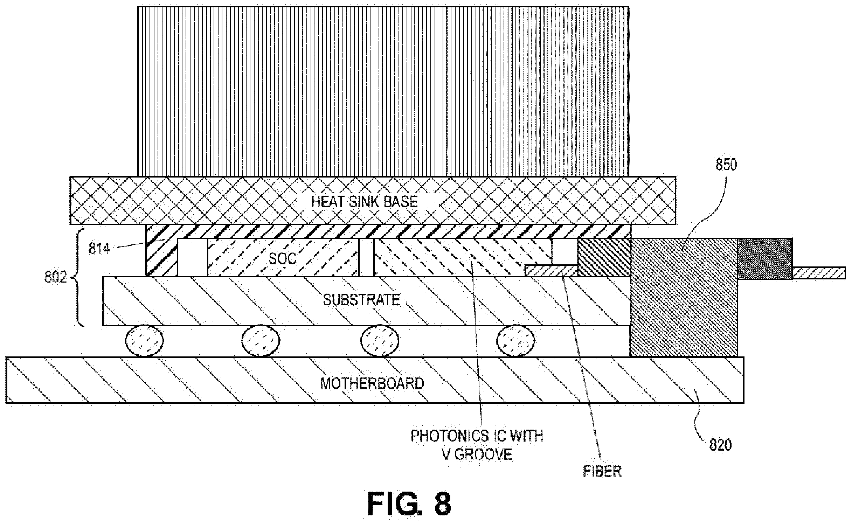

FIG. 8 illustrates an optical adapter mounted on a motherboard and coupled with a photonics package, in accordance with various embodiments. Photonics package 802 is coupled with a motherboard 820, which may be similar to photonics package 702 coupled with a motherboard 720 of FIG. 7. The photonics package 802 includes enhanced adapter 850. Enhanced adapter 850 is also referred to as an optical coupling apparatus.

According to the claimed invention, the enhanced adapter 850 is physically coupled to the motherboard 820, which may be similar to motherboard 120 of FIG. 1. The enhanced adapter 850 is electrically coupled with the motherboard 820. In embodiments, this electrical coupling may allow the enhanced adapter 850 to receive power from the motherboard. This electrical coupling allows the enhanced adapter 850 to communicate via electrical signals to transmit and receive data between the motherboard 820 and the enhanced adapter 850. This data may include telemetry data of the enhanced adapter 850. In embodiments, the enhanced adapter 850 may not be physically coupled with the substrate, which may be similar to substrate 104 of FIG. 1. In other embodiments, the enhanced adapter 850 may be partially coupled with heat spreader 814, which may be similar to heat spreader 114 of FIG. 1.

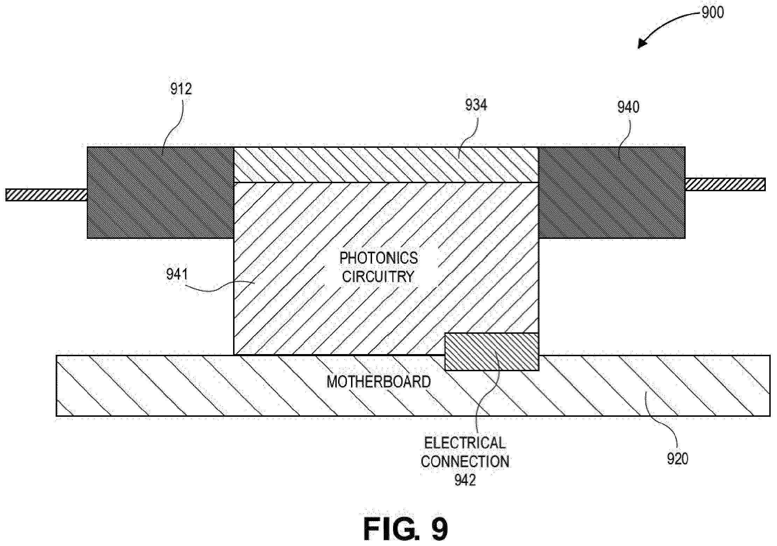

FIG. 9 illustrates details of an enhanced adapter, in accordance with various embodiments. Enhanced adapter 900 is similar to enhanced adapter 850 of FIG. 8. Enhanced adapter 900 may be coupled with external optical coupler 940, which may be similar to external optical coupler 740 of FIG. 7. Enhanced adapter 900 may also be coupled with optical coupler 912. Note that in embodiments, the optical coupler 912 may be similar to optical coupler 112 of FIG. 1.

Optical paths 934, which may be similar to optical paths to 234 of FIG. 2, couple light signals between the external optical coupler 940 and the optical coupler 912. In embodiments, the optical paths 934 may include waveguides, one or more optical fibers, or open air connectors to facilitate the optical coupling. In embodiments, the optical paths 934 may include one or more fibers that are single mode (SM), multimode (MM), or polarization maintaining (PM) fibers.

The enhanced adapter 900 also includes photonics circuitry 941, which may be similar to photonics circuitry 241 of FIG. 2. Photonics circuitry 941 may be used to sample and/or monitor the light traveling in the optical paths 934. In embodiments, the photonics circuitry may include one or more single-channel splitters, photodiodes, and other photonics-related components to sense and to collect operational data, such as a temperature sensor. The photonics circuitry 941 may also be used to monitor other operational aspects of the enhanced adapter 900 outside of optical performance, for example operating temperature of the enhanced adapter 900.

According to the claimed invention, the photonics circuitry 941 is electrically coupled via electrical connection 942, which may be similar to electrical connection 242 of FIG. 2, to a motherboard 920, which may be similar to motherboard 820 of FIG. 8. In embodiments, the motherboard 920 may be a substrate or a PCB. In embodiments, the electrical connection 942 may provide an electrical coupling with some other processing or storage component (not shown), for example with the PIC 306, and/or the SOC 308 of FIG. 3.

In embodiments, the electrical connection 942 may be an interconnect bridge, such as an EMIB, or a silicon interposer, organic routing on the motherboard 920, or a RDL on motherboard 920, or some other electrical coupling. In embodiments, the electrical coupling may be a high density electrical coupling. Using the electrical connection 942, data collected by the photonics circuitry 941 may enable telemetry data sent via the motherboard 920 regarding the operation of the enhanced adapter 900.

For example, the enhanced adapter 900 may actively draw current from the motherboard 904, or may leverage onboard amplifiers or pre-existing integrated circuits on the PIC 306, and/or the SOC 308 of FIG. 3 to measure, monitor, or store, for example, optical signal strength. In embodiments, the enhanced adapter 900, with varying components in the photonics circuitry 941, may be configured for benchtop, on-field, or final system-level testing.

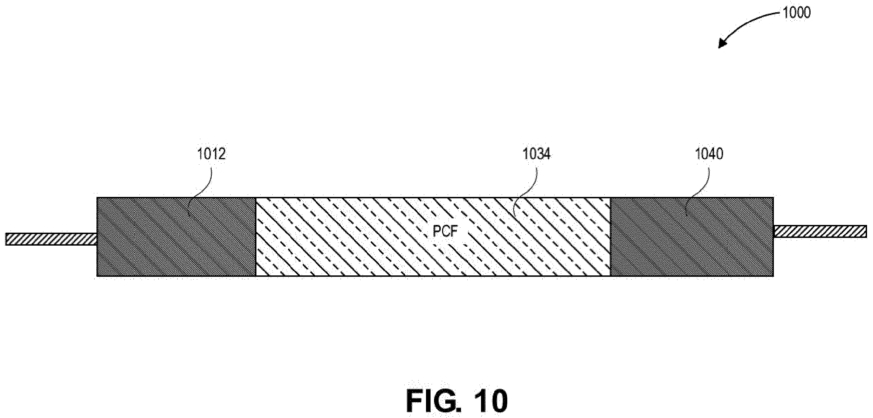

FIG. 10 illustrates an enhanced adapter that includes photonic crystal fiber (PCF), in accordance with various embodiments. Enhanced adapter 1000 shows at least part of the components of enhanced adapter 900 of FIG. 9. In embodiments, the enhanced adapter 1000 may optically couple with an external optical coupler 1040, which may be similar to external optical coupler 940 of FIG. 9. The enhanced adapter 1000 may also optically couple with optical coupler 1012, which may be similar to optical coupler 912 of FIG. 9.

Optical paths 1034, which may be similar to optical paths 934 of FIG. 9, may include one or more optical fibers that are a photonic crystal fibers (PCF). In embodiments, PCFs may act as a physical sensor for temperature. In embodiments, the photonics circuitry 941 of FIG. 9 may receive and/or process this temperature data and provide it to other components as described above. In embodiments, the optical paths 1034 that include PCF may be included within enhanced adapter 850 of FIG. 8.

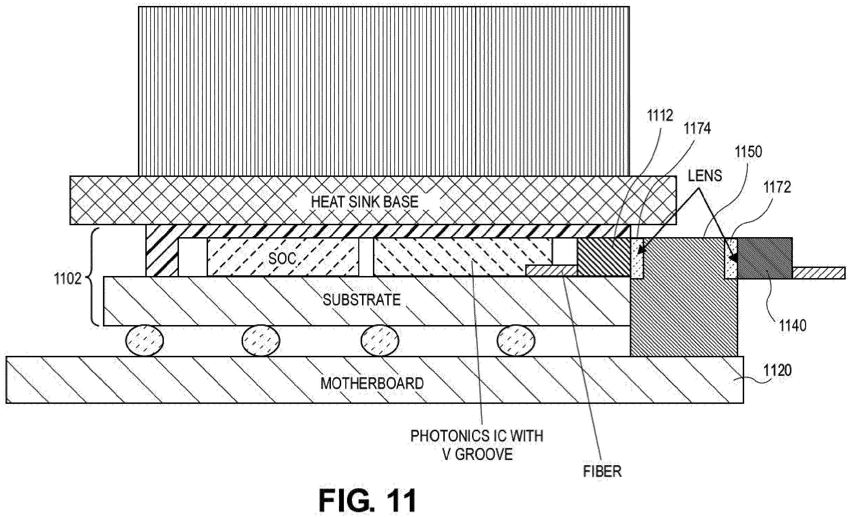

FIG. 11 illustrates an optical adapter mounted on a motherboard that includes optical lenses coupled with a photonics package, in accordance with various embodiments. Photonics package 1102 is coupled with a motherboard 1120, which may be similar to photonics package 702 and a motherboard 720 of FIG. 7. Motherboard 1120 includes enhanced adapter 1150. As shown, enhanced adapter 1150 may include lenses 1172, 1174 that are disposed respectively, adjacent to external optical coupler 1140, which may be similar to external optical coupler 740 of FIG. 7, and may be adjacent to optical coupler 1112.

In embodiments, the lenses 1172, 1174 may be lens arrays with a plurality of lenses to each transmit an optical channel. In embodiments, the enhanced adapter 1150 may not contain any optical fibers, and instead use waveguides or open-air channels to optically couple the lenses 1172, 1174.

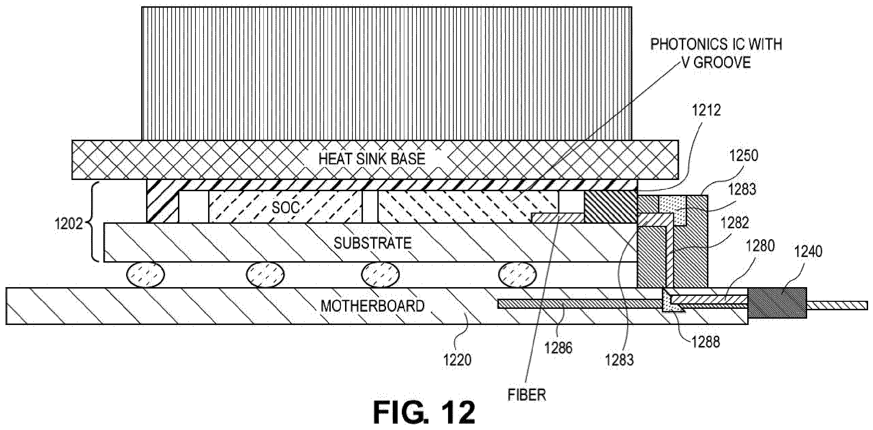

FIG. 12 illustrates an optical adapter mounted on a motherboard that includes an optical pathway to optically couple and optical layer of the motherboard with the photonics package, in accordance with various embodiments. Photonics package 1202 that is coupled with a motherboard 1220, which may be similar to photonics package 702 coupled with a motherboard 720 of FIG. 7, includes an enhanced adapter 1250.

In this embodiment, the enhanced adapter 1250 may include one or more optical paths 1282, 1283 to optically couple with optical coupler 1212. The one or more optical paths 1282, 1283 may optically couple with optical path 1280 within an optical layer 1286 of motherboard 1220, which may be similar to motherboard 720 of FIG. 7.

In this embodiment, there may be multiple optical routing features 1283, such as mirrors or reflectors, that may be included within the enhanced adapter 1250 to properly route the optical signals down optical paths 1282, 1283. In embodiments, the optical layer 1286 may include optical routing features 1288, such as mirrors or reflectors, to route optical signals received from an external optical coupler 1240. As shown, the external optical coupler 1240 may be optically coupled with the motherboard 1220. In embodiments, there may be coupling features (not shown) at an edge of the motherboard 1220 to physically and optically align external optical coupler 1240 with the with the optical layer 1286 of motherboard 1220.

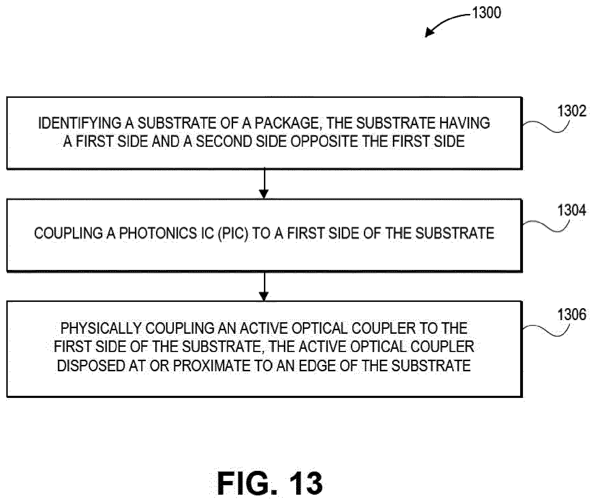

FIG. 13 is a process for implementing an active optical coupler with a photonics package, not according to the claimed invention. Process 1300 may be implemented using apparatus, systems, techniques, or processes as described herein, and in particular with respect to FIGs. 1-12.

At block 1302, the process includes identifying a substrate of a package, the substrate having a first side and a second side opposite the first side. The substrate may be similar to at least substrate 104 of FIG. 1, 204 of FIG. 2, 304 of FIG. 3, the substrate FIG. 4, and the substrate of FIG. 8. In embodiments, the first side of the substrate may be an active side, and the second side of the substrate may be a bottom side.

At block 1304, the process may further include coupling a PIC to the first side of the substrate. The PIC may at least be similar to PIC 106 of FIG. 1 and PIC 306 of FIG. 3, and as shown elsewhere in the Figures.

At block 1306, the process may further include physically coupling an enhanced optical coupler to the first side of the substrate, the active optical coupler disposed at or proximate to an edge of the substrate. The active optical coupler may include at least active optical couplers shown in the Figures.

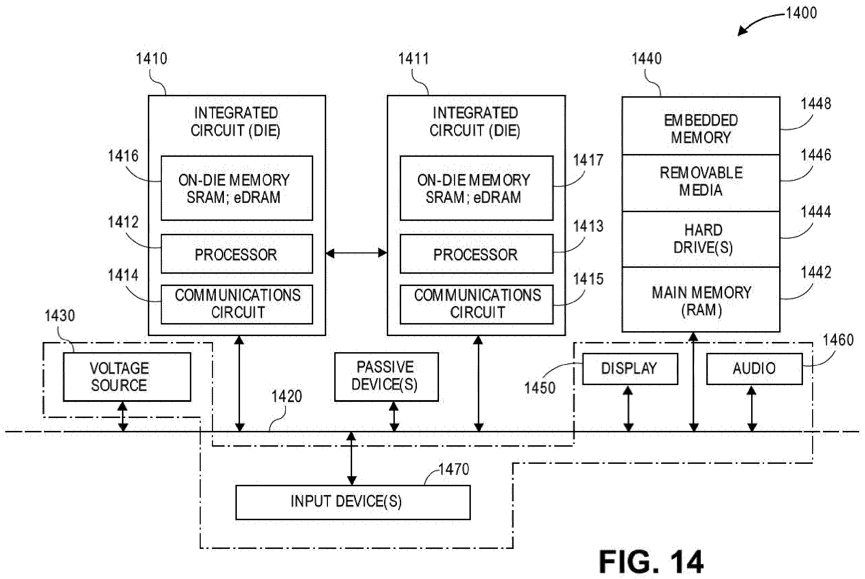

FIG. 14 is a schematic of a computer system 1400 not according to the claimed invention. The computer system 1400 (also referred to as the electronic system 1400) as depicted can embody an active optical coupler, according to any of the several disclosed embodiments and their equivalents as set forth in this disclosure. The computer system 1400 may be a mobile device such as a netbook computer. The computer system 1400 may be a mobile device such as a wireless smart phone. The computer system 1400 may be a desktop computer. The computer system 1400 may be a hand-held reader. The computer system 1400 may be a server system. The computer system 1400 may be a supercomputer or high-performance computing system.

In an embodiment, the electronic system 1400 is a computer system that includes a system bus 1420 to electrically couple the various components of the electronic system 1400. The system bus 1420 is a single bus or any combination of busses according to various embodiments. The electronic system 1400 includes a voltage source 1430 that provides power to the integrated circuit 1410. In some embodiments, the voltage source 1430 supplies current to the integrated circuit 1410 through the system bus 1420.

The integrated circuit 1410 is electrically coupled to the system bus 1420 and includes any circuit, or combination of circuits according to an embodiment. In an embodiment, the integrated circuit 1410 includes a processor 1412 that can be of any type. As used herein, the processor 1412 may mean any type of circuit such as, but not limited to, a microprocessor, a microcontroller, a graphics processor, a digital signal processor, or another processor. In an embodiment, the processor 1412 includes, or is coupled with, a component that includes an active optical coupler, as disclosed herein. In an embodiment, SRAM embodiments are found in memory caches of the processor. Other types of circuits that can be included in the integrated circuit 1410 are a custom circuit or an application-specific integrated circuit (ASIC), such as a communications circuit 1414 for use in wireless devices such as cellular telephones, smart phones, pagers, portable computers, two-way radios, and similar electronic systems, or a communications circuit for servers. In an embodiment, the integrated circuit 1410 includes on-die memory 1416 such as static random-access memory (SRAM). In an embodiment, the integrated circuit 1410 includes embedded on-die memory 1416 such as embedded dynamic random-access memory (eDRAM).

In an embodiment, the integrated circuit 1410 is complemented with a subsequent integrated circuit 1411. Useful embodiments include a dual processor 1413 and a dual communications circuit 1415 and dual on-die memory 1417 such as SRAM. In an embodiment, the dual integrated circuit 1410 includes embedded on-die memory 1417 such as eDRAM.

In an embodiment, the electronic system 1400 also includes an external memory 1440 that in turn may include one or more memory elements suitable to the particular application, such as a main memory 1442 in the form of RAM, one or more hard drives 1444, and/or one or more drives that handle removable media 1446, such as diskettes, compact disks (CDs), digital variable disks (DVDs), flash memory drives, and other removable media known in the art. The external memory 1440 may also be embedded memory 1448 such as the first die in a die stack, according to an embodiment.

In an embodiment, the electronic system 1400 also includes a display device 1450, an audio output 1460. In an embodiment, the electronic system 1400 includes an input device such as a controller 1470 that may be a keyboard, mouse, trackball, game controller, microphone, voice-recognition device, or any other input device that inputs information into the electronic system 1400. In an embodiment, an input device 1470 is a camera. In an embodiment, an input device 1470 is a digital sound recorder. In an embodiment, an input device 1470 is a camera and a digital sound recorder.

As shown herein, the integrated circuit 1410 can be implemented in a number of different embodiments, including a package substrate having an active optical coupler, according to any of the several disclosed embodiments and their equivalents, an electronic system, a computer system, one or more methods of fabricating an integrated circuit, and one or more methods of fabricating an electronic assembly that includes a package substrate having an active optical coupler, according to any of the several disclosed embodiments as set forth herein in the various embodiments and their art-recognized equivalents. The elements, materials, geometries, dimensions, and sequence of operations can all be varied to suit particular I/O coupling requirements including array contact count, array contact configuration for a microelectronic die embedded in a processor mounting substrate according to any of the several disclosed package substrates having an active optical coupler embodiments and their equivalents. A foundation substrate may be included, as represented by the dashed line of FIG. 14. Passive devices may also be included, as is also depicted in FIG. 14.

Modifications may be made to the embodiments in light of the above detailed description. The terms used in the following claims should not be construed to limit the embodiments to the specific implementations disclosed in the specification. The scope of the invention is to be determined entirely by the following claims.

## Claims

1. A system comprising:
a motherboard (820, 920);
a photonics package (802) coupled with the motherboard (820, 920) comprising:
a substrate;
a photonics integrated circuit, PIC, coupled with the substrate;
and a system-on-a-chip coupled with the substrate;
the system further comprising an active optical coupler apparatus (850, 900) comprising:
a first optical interface (230) to receive or transmit one or more light signals;
a second optical interface (236) to receive or transmit the one or more light signals;
a photonics circuitry (941) optically coupled with the first optical interface (230) or the second optical interface (236) to monitor operation of the active optical coupler apparatus (850, 900);
an electrical connection (942) coupled with the photonics circuitry (941) to facilitate the monitoring of the active optical coupler apparatus (850, 900); and
wherein the first optical interface (230) and the second optical interface (236) are optically coupled to allow light received by the first optical interface (230) to be transmitted to the second optical interface (236) and light received by the second optical interface (236) to be transmitted to the first optical interface (230),
wherein the active optical coupler apparatus (850, 900) is physically coupled with the motherboard (920), and
wherein the electrical connection (942) is electrically coupled with the motherboard (920), to provide an electrical coupling with the photonics circuitry (941).

2. The system of claim 1, wherein the electrical connection (942) with the motherboard (920) is to provide power to the active optical coupler apparatus (900).

3. The system of claim 1 or 2, wherein the photonics circuitry includes one or more photonic diodes.

4. The system of one of the previous claims, wherein the first optical interface (230) is optically coupled with the PIC outside the active optical coupler apparatus (850).

5. The system of claim 4, wherein the first optical interface (230) is optically coupled with the PIC outside the active optical coupler apparatus (850) by a selected one of: an optical waveguide or an optical fiber

6. The system of one of the previous claims, further including a socket mechanism coupled to the second optical interface (236), the socket mechanism to receive an optical fiber housing that includes one or more optical fibers.

7. A method of fabricating a system comprising:
providing a motherboard;
providing a photonics package coupled with the motherboard comprising:
providing a substrate;
providing a photonics integrated circuit coupled with the substrate; and
providing a system-on-a-chip coupled with the substrate;
providing an active optical coupler apparatus, comprising:
providing a first optical interface to receive or transmit one or more light signals;
providing a second optical interface to receive or transmit the one or more light signals;
coupling photonics circuitry optically with the first optical interface or the second optical interface to monitor operation of the active optical coupler apparatus;
coupling an electrical connection with the photonics circuitry to facilitate the monitoring of the active optical coupler apparatus; and
wherein the first optical interface and the second optical interface are optically coupled to allow light received by the first optical interface to be transmitted to the second optical interface and light received by the second optical interface to be transmitted to the first optical interface,
wherein the active optical coupler apparatus is physically coupled with the motherboard, and wherein the electrical connection is electrically coupled with the motherboard, to provide an electrical coupling with the photonics circuitry.

8. The method of claim 7, wherein the electrical coupling with the motherboard is to provide power to the active optical coupler apparatus.

9. The method of claim 7 or 8, wherein the photonics circuitry includes one or more photonic diodes.

10. The method of claim 7, 8 or 9, wherein to monitor operation of the active optical coupler apparatus further includes to identify data related to operational characteristics of the operation of the active optical coupler apparatus.

## Patentansprüche

1. System, das Folgendes umfasst:
eine Hauptplatine (820, 920);
ein Photonikgehäuse (802), das mit der Hauptplatine (820, 920) gekoppelt ist, das Folgendes umfasst:
ein Substrat;
eine integrierte Photonikschaltung, PIC, die mit dem Substrat gekoppelt ist;
und ein System-on-a-Chip, das mit dem Substrat gekoppelt ist;
wobei das System ferner eine aktive optische Kopplereinrichtung (850, 900) umfasst, die Folgendes umfasst:
eine erste optische Schnittstelle (230), um ein oder mehrere Lichtsignale zu empfangen oder zu übertragen; eine zweite optische Schnittstelle (236), um das eine oder die mehreren Lichtsignale zu empfangen oder zu übertragen;
eine Photonikschaltungsanordnung (941), die optisch mit der ersten optischen Schnittstelle (230) oder der zweiten optischen Schnittstelle (236) gekoppelt ist, um einen Betrieb der aktiven optischen Kopplereinrichtung (850, 900) zu überwachen;
eine elektrische Verbindung (942), die mit der Photonikschaltungsanordnung (941) gekoppelt ist, um die Überwachung der aktiven optischen Kopplereinrichtung (850, 900) zu erleichtern; und
wobei die erste optische Schnittstelle (230) und die zweite optische Schnittstelle (236) optisch gekoppelt sind, um zu ermöglichen, dass durch die erste optische Schnittstelle (230) empfangenes Licht zu der zweiten optischen Schnittstelle (236) übertragen wird und durch die zweite optische Schnittstelle (236) empfangenes Licht zu der ersten optischen Schnittstelle (230) übertragen wird,
wobei die aktive optische Kopplereinrichtung (850, 900) physisch mit der Hauptplatine (920) gekoppelt ist, und wobei die elektrische Verbindung (942) elektrisch mit der Hauptplatine (920) gekoppelt ist, um eine elektrische Kopplung mit der Photonikschaltungsanordnung (941) bereitzustellen.

2. System nach Anspruch 1, wobei die elektrische Verbindung (942) mit der Hauptplatine (920) dazu dient, der aktiven optischen Kopplereinrichtung (900) Leistung bereitzustellen.

3. System nach Anspruch 1 oder 2, wobei die Photonikschaltungsanordnung eine oder mehrere Photonikdioden aufweist.

4. System nach einem der vorhergehenden Ansprüche, wobei die erste optische Schnittstelle (230) außerhalb der aktiven optischen Kopplereinrichtung (850) optisch mit der PIC gekoppelt ist.

5. System nach Anspruch 4, wobei die erste optische Schnittstelle (230) außerhalb der aktiven optischen Kopplereinrichtung (850) durch ein ausgewähltes von Folgendem optisch mit der PIC gekoppelt ist: einen optischen Wellenleiter oder eine optische Faser.

6. System nach einem der vorhergehenden Ansprüche, das ferner Folgendes aufweist
einen Buchsenmechanismus, der mit der zweiten optischen Schnittstelle (236) gekoppelt ist, wobei der Buchsenmechanismus dazu dient, ein optisches Fasergehäuse aufzunehmen, das eine oder mehrere optische Fasern aufweist.

7. Verfahren zum Fertigen eines Systems, das Folgendes umfasst:
Bereitstellen einer Hauptplatine;
Bereitstellen eines Photonikgehäuses, das mit der Hauptplatine gekoppelt ist, umfassend:
Bereitstellen eines Substrats;
Bereitstellen einer integrierten Photonikschaltung, die mit dem Substrat gekoppelt ist; und
Bereitstellen eines System-on-a-Chip, das mit dem Substrat gekoppelt ist;
Bereitstellen einer aktiven optischen Kopplereinrichtung, umfassend:
Bereitstellen einer ersten optischen Schnittstelle, um ein oder mehrere Lichtsignale zu empfangen oder zu übertragen;
Bereitstellen einer zweiten optischen Schnittstelle, um das eine oder die mehreren Lichtsignale zu empfangen oder zu übertragen;
optisches Koppeln der Photonikschaltungsanordnung mit der ersten optischen Schnittstelle oder der zweiten optischen Schnittstelle, um einen Betrieb der aktiven optischen Kopplereinrichtung zu überwachen;
Koppeln einer elektrischen Verbindung mit der Photonikschaltungsanordnung, um die Überwachung der aktiven optischen Kopplereinrichtung zu erleichtern; und wobei die erste optische Schnittstelle und die zweite optische Schnittstelle optisch gekoppelt sind, um zu ermöglichen, dass durch die erste optische Schnittstelle empfangenes Licht zu der zweiten optischen Schnittstelle übertragen wird und durch die zweite optische Schnittstelle empfangenes Licht zu der ersten optischen Schnittstelle übertragen wird,
wobei die aktive optische Kopplereinrichtung physisch mit der Hauptplatine gekoppelt ist, und wobei die elektrische Verbindung elektrisch mit der Hauptplatine gekoppelt ist, um eine elektrische Kopplung mit der Photonikschaltungsanordnung bereitzustellen.

8. Verfahren nach Anspruch 7, wobei die elektrische Kopplung mit der Hauptplatine dazu dient, der aktiven optischen Kopplereinrichtung Leistung bereitzustellen.

9. Verfahren nach Anspruch 7 oder 8, wobei die Photonikschaltungsanordnung eine oder mehrere Photonikdioden aufweist.

10. Verfahren nach Anspruch 7, 8 oder 9, wobei das Überwachen eines Betriebs der aktiven optischen Kopplereinrichtung ferner Identifizieren von Daten in Bezug auf Betriebscharakteristiken des Betriebs der aktiven optischen Kopplereinrichtung beinhaltet.

## Revendications

1. Système comprenant :
une carte mère (820, 920) ;
un boîtier photonique (802) couplé à la carte mère (820, 920) comprenant :
un substrat ;
un circuit intégré photonique, PIC, couplé au substrat ; et un système sur puce couplé au substrat ;
le système comprenant en outre un appareil de couplage optique actif (850, 900) comprenant :
une première interface optique (230) pour recevoir ou transmettre un ou plusieurs signaux lumineux ;
une deuxième interface optique (236) pour recevoir ou transmettre le ou les signaux lumineux ;
des circuits photoniques (941) couplés optiquement à la première interface optique (230) ou à la deuxième interface optique (236) pour surveiller le fonctionnement de l'appareil de couplage optique actif (850, 900) ;
une connexion électrique (942) couplée aux circuits photoniques (941) pour faciliter la surveillance de l'appareil de couplage optique actif (850, 900) ; et
dans lequel la première interface optique (230) et la deuxième interface optique (236) sont couplées optiquement pour permettre la transmission de la lumière reçue par la première interface optique (230) à la deuxième interface optique (236) et la transmission de la lumière reçue par la deuxième interface optique (236) à la première interface optique (230),
dans lequel l'appareil de couplage optique actif (850, 900) est couplé physiquement à la carte mère (920), et dans lequel la connexion électrique (942) est couplée électriquement à la carte mère (920), pour assurer un couplage électrique avec les circuits photoniques (941).

2. Système de la revendication 1, dans lequel la connexion électrique (942) avec la carte mère (920) sert à alimenter l'appareil de couplage optique actif (900).

3. Système de la revendication 1 ou 2, dans lequel les circuits photoniques comportent une ou plusieurs diodes photoniques.

4. Système d'une des revendications précédentes, dans lequel la première interface optique (230) est couplée optiquement au PIC à l'extérieur de l'appareil de couplage optique actif (850).

5. Système de la revendication 4, dans lequel la première interface optique (230) est couplée optiquement au PIC à l'extérieur de l'appareil de couplage optique actif (850) par un élément choisi parmi un guide d'ondes optiques et une fibre optique.

6. Système d'une des revendications précédentes, comportant en outre
un mécanisme de prise couplé à la deuxième interface optique (236), le mécanisme de prise servant à recevoir un boîtier à fibre optique qui comporte une ou plusieurs fibres optiques.

7. Procédé de fabrication d'un système comprenant :
l'obtention d'une carte mère ;
l'obtention d'un boîtier photonique couplé à la carte mère, ce qui comprend :
l'obtention d'un substrat ;
l'obtention d'un circuit intégré photonique couplé au substrat ; et
l'obtention d'un système sur puce couplé au substrat ; l'obtention d'un appareil de couplage optique actif, ce qui comprend :
l'obtention d'une première interface optique pour recevoir ou transmettre un ou plusieurs signaux lumineux ;
l'obtention d'une deuxième interface optique pour recevoir ou transmettre le ou les signaux lumineux ;
le couplage optique de circuits photoniques avec la première interface optique ou avec la deuxième interface optique pour surveiller le fonctionnement de l'appareil de couplage optique actif ;
le couplage d'une connexion électrique avec les circuits photoniques pour faciliter la surveillance de l'appareil de couplage optique actif ; et
dans lequel la première interface optique et la deuxième interface optique sont couplées optiquement pour permettre la transmission de la lumière reçue par la première interface optique à la deuxième interface optique et la transmission de la lumière reçue par la deuxième interface optique à la première interface optique,
dans lequel l'appareil de couplage optique actif est couplé physiquement à la carte mère, et dans lequel la connexion électrique est couplée électriquement à la carte mère, pour assurer un couplage électrique avec les circuits photoniques.

8. Procédé de la revendication 7, dans lequel le couplage électrique avec la carte mère sert à alimenter l'appareil de couplage optique actif.

9. Procédé de la revendication 7 ou 8, dans lequel les circuits photoniques comportent une ou plusieurs diodes photoniques.

10. Procédé de la revendication 7, 8 ou 9, dans lequel la surveillance du fonctionnement de l'appareil de couplage optique actif comporte en outre l'identification de données relatives à des caractéristiques opérationnelles du fonctionnement de l'appareil de couplage optique actif.
